(19) **Europäisches Patentamt**
**European Patent Office**
**Office européen des brevets**

(11) **EP 3 664 170 B1**

(12) **FASCICULE DE BREVET EUROPEEN**

(45) Date de publication et mention
de la délivrance du brevet:
**04.05.2022 Bulletin 2022/18**

(51) Classification Internationale des Brevets (IPC):
**H01L 33/00** (2010.01)   **H01L 33/56** (2010.01)
H01L 33/30 (2010.01)   H01L 33/54 (2010.01)

(21) Numéro de dépôt: **19211993.1**

(22) Date de dépôt: **28.11.2019**

(52) Classification Coopérative des Brevets (CPC):
**H01L 33/56;** H01L 33/30; H01L 33/54;
H01L 2933/005

(54) **PROCÉDÉ D'ADAPTATION DE L'EFFICACITÉ DE L'EXTRACTION LUMINEUSE D'UNE DIODE ÉLECTROLUMINESCENTE**

ANPASSUNGSVERFAHREN DER LICHTEXTRAKTIONSEFFIZIENZ EINER LEUCHTDIODE

METHOD OF ADAPTING LIGHT EXTRACTION EFFICIENCY FROM A LIGHT EMITTING DIODE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **06.12.2018 FR 1872425**

(43) Date de publication de la demande:
**10.06.2020 Bulletin 2020/24**

(73) Titulaire: **Commissariat à l'énergie atomique
et aux énergies alternatives
75015 Paris (FR)**

(72) Inventeurs:
• **DAAMI, Anis
38054 GRENOBLE CEDEX 09 (FR)**
• **CONSONNI, Marianne
38054 GRENOBLE CEDEX 09 (FR)**

(74) Mandataire: **Brevalex
95, rue d'Amsterdam
75378 Paris Cedex 8 (FR)**

(56) Documents cités:
**US-A- 3 834 883**

• **MING MA ET AL: "Effects of the refractive index
of the encapsulant on the light-extraction
efficiency of light-emitting diodes", OPTICS
EXPRESS, vol. 19, no. S5, 12 septembre 2011
(2011-09-12), page A1135, XP055607144, US
ISSN: 2161-2072, DOI: 10.1364/OE.19.0A1135**
• **MOULIN G ET AL: "An Efficient Process of
Surface Modification and Patterning for LED
Encapsulation", IEEE TRANSACTIONS ON
COMPONENTS, PACKAGING AND
MANUFACTURING TECHNOLOGY, IEEE, USA,
vol. 8, no. 5, 1 mai 2018 (2018-05-01), pages
904-909, XP011683143, ISSN: 2156-3950, DOI:
10.1109/TCPMT.2018.2811178 [extrait le
2018-05-08]**

**Description**

**DOMAINE TECHNIQUE**

La présente invention concerne un procédé de fabrication de diodes électroluminescentes. En particulier, la présente invention concerne un procédé de fabrication de diodes électroluminescentes permettant d'ajuster à une valeur prédéterminée, notamment à une valeur maximale, le rendement quantique externe desdites diodes.

**ÉTAT DE LA TECHNIQUE ANTÉRIEURE**

Le rendement quantique externe des diodes électroluminescentes est défini par le produit du rendement quantique interne (IQE) et de l'efficacité de l'extraction lumineuse (LEE).

Ce dernier terme, généralement inférieur à un, rend compte de phénomènes parasites qui ont pour conséquence de dégrader le rendement global des diodes électroluminescentes.

Parmi ces phénomènes parasites, les réflexions internes et/ou réabsorptions des rayonnements lumineux par les diodes électroluminescentes jouent un rôle prépondérant dans cette dégradation.

Ainsi, afin d'optimiser l'efficacité de l'extraction lumineuse, il a pu être proposé de texturer certaines surfaces des diodes afin de limiter les réflexions internes.

À cet égard, le document [1], cité à la fin de la description, propose des diodes électroluminescentes recouvertes par une couche texturée, et notamment rugueuse.

De manière alternative, dans le document [2] cité à la fin de la description, les diodes électroluminescentes reposent sur un réseau de structures, et notamment des structures coniques.

Enfin, les documents [3] et [4], cités à la fin de la description, divulguent une texturation d'une surface exposée des diodes électroluminescentes.

Toutefois, les procédés de texturation proposés dans l'état de la technique antérieur ne sont pas satisfaisants.

En effet, les inventeurs ont noté que le rendement quantique externe d'une diode est également dépendant de la taille, et notamment du rapport de forme de la surface de ladite diode.

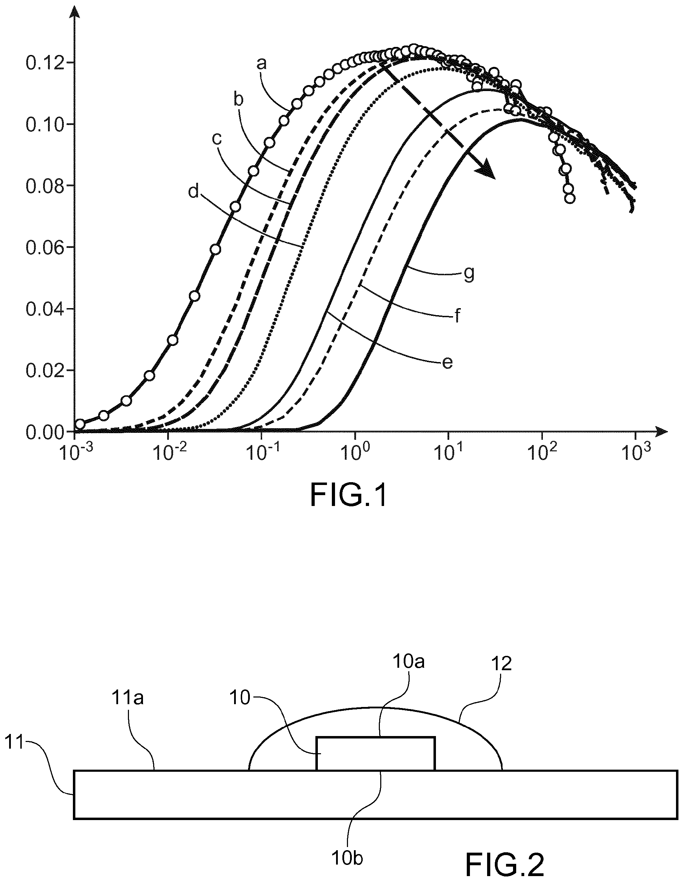

Plus particulièrement, tel qu'illustré à la figure 1, plus la taille de la diode diminue plus le rendement quantique diminue.

Par ailleurs, le rendement maximum est atteint pour des densités de courant croissantes au fur et à mesure que la taille de la diode diminue.

Ainsi, la texturation telle que proposée dans les documents précités rend l'atteinte d'un rendement quantique externe maximum difficile, et surtout dépendant de la taille de la diode concernée.

Dans la mesure où les diodes de petite taille sont aujourd'hui abondamment mises en œuvre dans les dispositifs optiques, et notamment dans les afficheurs haute résolution, il est essentiel de pouvoir répondre à la problématique posée par l'optimisation du rendement quantique externe.

Le document de Ming Ma et al., intitulé: "Effects of the refractive index of the encapsulant on the light-extraction efficiency of light-emitting diodes", Optics Express, vol. 19, no. S5, 12 septembre 2011, pages A1135-A1140, porte sur une étude de l'efficacité de l'extraction lumineuse d'une diode électroluminescente. La présente invention a donc pour but de proposer un procédé
d'adaptation du rendement quantique externe de diodes électroluminescentes.

Un autre but de la présente invention est de proposer un procédé permettant de maximiser le rendement quantique externe de diodes électroluminescentes.

**EXPOSÉ DE L'INVENTION**

Les buts de la présente invention sont atteints par un procédé selon les termes de la revendication 1 en annexe.

D'autres modes avantageux de mise en œuvre de la présente invention sont l'objet des revendications dépendantes en annexe.

L'invention concerne un procédé d'adaptation de l'efficacité de l'extraction lumineuse LEE d'au moins une diode électroluminescente de surface S et de périmètre P, le procédé comprenant une étape d'encapsulation de la diode électroluminescente par une couche d'encapsulation présentant un indice de réfraction N, l'indice de réfraction N étant déterminé sur la base d'un modèle rendant compte d'un rendement quantique interne IQE de la diode électroluminescente, et de sorte que l'efficacité de l'extraction lumineuse résultant de la mise en œuvre de la couche d'encapsulation permette à la diode électroluminescente d'atteindre un rendement quantique externe prédéterminé $EQE_K$.

Le modèle est, à cet égard, fonction du rapport du périmètre P sur la surface S de la diode électroluminescente.

Selon un mode de mise en œuvre, le modèle rendant compte du rendement quantique interne IQE vérifie la relation suivante :

$$IQE = \frac{B.n^2}{A'.\frac{P}{S}.n + B.n^2 + C.n^3}$$

Où:

A'.P/S est un coefficient de recombinaison Shockley-Read-Hall (SRH) non radiative,
B est un coefficient de recombinaison radiative,
C est un coefficient de recombinaison Auger non radiative,
n est une densité de porteurs injectés,
P est le périmètre de la diode électroluminescente,
S est la surface de la diode électroluminescente.

Selon un mode de mise en œuvre, la détermination de l'indice de réfraction N comprend une simulation de trajets de rayons lumineux émis par une source lambertienne encapsulée par la couche d'encapsulation.

Selon un mode de mise en œuvre, la simulation est effectuée pour une gamme d'indices de réfraction de la couche d'encapsulation.

Selon un mode de mise en œuvre, la détermination de l'indice de réfraction N comprend la construction d'un abaque mettant en relation l'extraction lumineuse permise par la couche d'encapsulation et l'extraction lumineuse requise pour que le rendement quantique externe de la diode soit égal au rendement quantique externe prédéterminé $EQE_K$.

Selon un mode de mise en œuvre, le rendement quantique externe prédéterminé $EQE_K$ correspond à une valeur maximale $EQE_{max}$ du rendement quantique atteignable par la diode électroluminescente.

Selon un mode de mise en œuvre, la couche d'encapsulation forme un dôme.

Selon un mode de mise en œuvre, le rapport périmètre P sur surface S est supérieur à un dixième.

Selon un mode de mise en œuvre, on adapte l'efficacité de l'extraction lumineuse LEE d'une pluralité de diodes électroluminescentes identiques.

Selon un mode de mise en œuvre, on adapte l'efficacité de l'extraction lumineuse LEE d'une pluralité de diodes électroluminescentes de tailles différentes.

Selon un mode de mise en œuvre, l'au moins une diode électroluminescente comprend un empilement de matériaux semi-conducteurs III-V.

## BRÈVE DESCRIPTION DES DESSINS

D'autres caractéristiques et avantages apparaîtront dans la description qui va suivre d'un procédé d'adaptation du rendement quantique externe d'une diode électroluminescente, donnés à titre d'exemples non limitatifs, en référence aux dessins annexés dans lesquels :

La figure 1 est une représentation graphique du rendement quantique externe d'une diode électroluminescente (selon l'axe vertical, en unité arbitraire avec un maximum égal à 1) en fonction de la densité de courant traversant ladite diode (axe horizontal, « A/cm$^2$ »), les différentes courbes « a », « b », « c », « d », « e », « f », et « g » étant relatives à des diodes électroluminescentes de taille de, respectivement, 500 $\mu$m, 200 $\mu$m, 100 $\mu$m, 50 $\mu$m, 20 $\mu$m, 15 $\mu$m et 10 $\mu$m de côté ;

La figure 2 est une représentation schématique d'une diode électroluminescente reposant, par sa face arrière, sur une face avant d'un substrat support, mise en œuvre dans la cadre de la présente invention ;

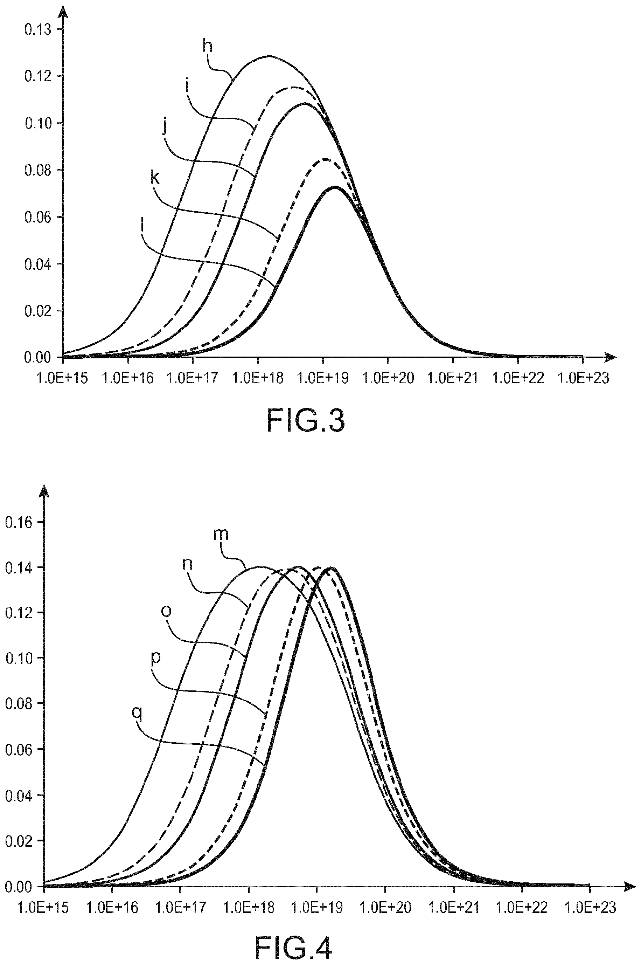

La figure 3 est une représentation graphique du rendement quantique externe d'une diode électroluminescente (selon l'axe vertical, unité arbitraire avec un maximum égal à 1) en fonction de la densité de porteurs traversants ladite diode (axe horizontal, « cm$^{-3}$ »), obtenu par simulation, les différentes courbes « h », « i », « j », « k », et « l » étant relatives à des diodes électroluminescentes de taille de, respectivement, 500 $\mu$m, 100 $\mu$m, 50 $\mu$m, 10 $\mu$m et 5 $\mu$m de côté ;

La figure 4 est une représentation graphique du rendement quantique externe d'une diode électroluminescente (selon l'axe vertical, en unité arbitraire avec un maximum égal à 1) en fonction de la densité porteurs traversants ladite diode (axe horizontal, « cm$^{-3}$ »), obtenu par simulation et modulation de l'extraction lumineuse, les différentes courbes « m », « n », « o », « p », et « q » étant relatives à des diodes électroluminescentes de taille de, respectivement, 500 $\mu$m, 100 $\mu$m, 50 $\mu$m, 10 $\mu$m et 5 $\mu$m de côté;

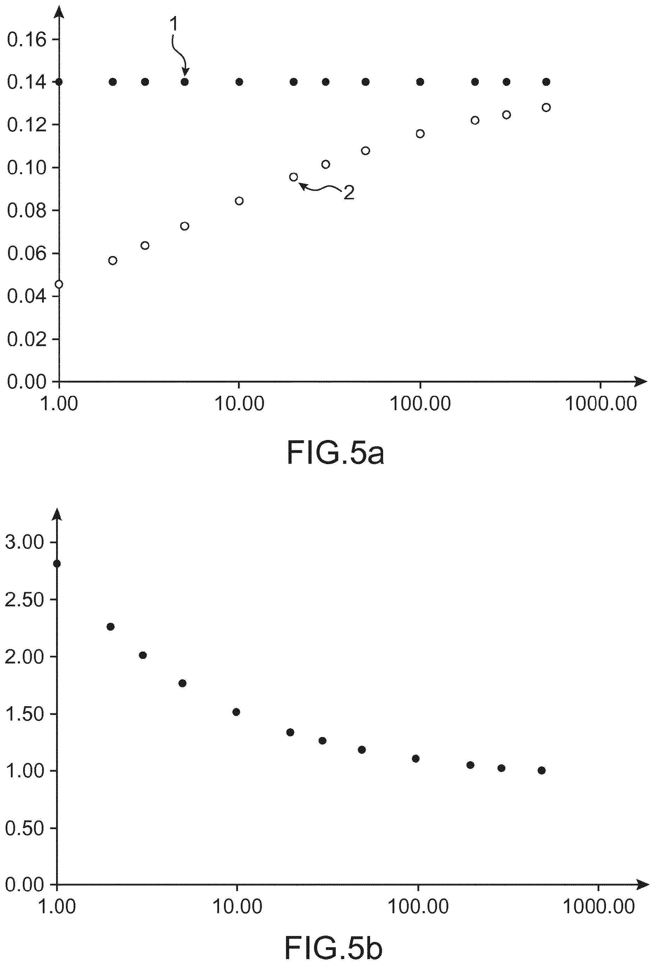

Les figures 5a et 5b sont des illustrations de l'évolution du gain, la figure 5a représente notamment le rendement quantique externe d'une diode électroluminescente avec (courbe 1) et sans (courbe 2) gain relatif à la modulation de l'extraction lumineuse en fonction de la taille de ladite diode (axe horizontal, en « μm »), la figure 5b représente le gain requis appliqué pour chaque taille de diode ;

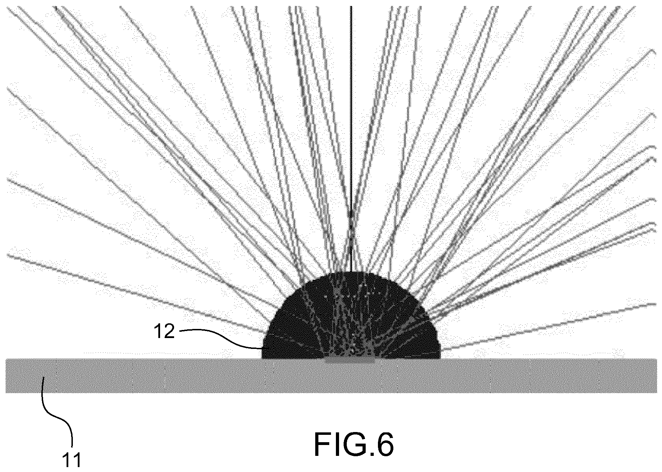

La figure 6 est une représentation schématique des rayonnements lumineux issus d'une diode encapsulée par une couche d'encapsulation ;

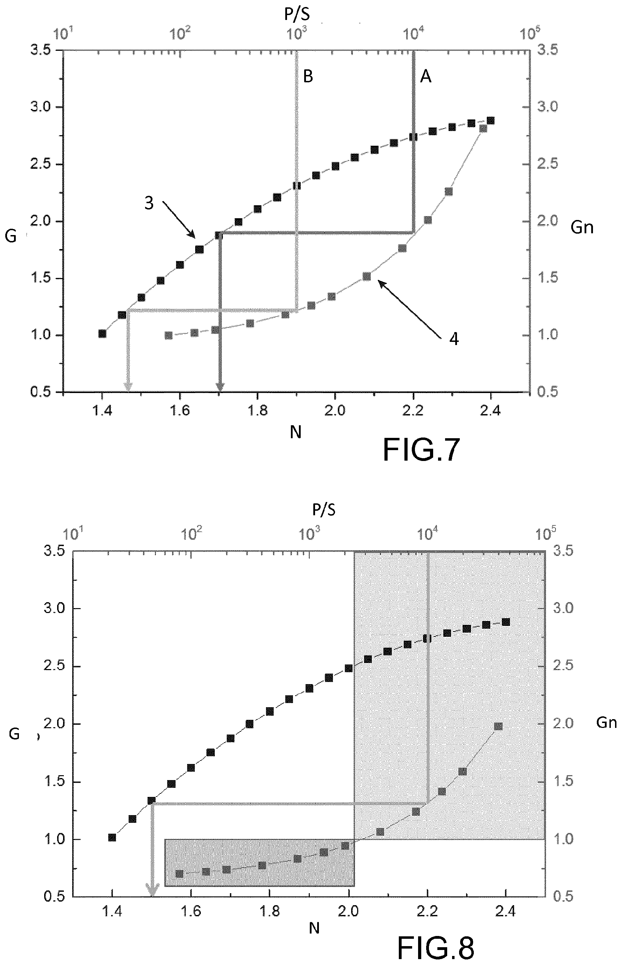

La figure 7 est un abaque permettant, en fonction de la géométrie de la diode, de déterminer l'indice de réfraction N de la couche d'encapsulation pour que le rendement quantique externe de ladite diode soit maximum, en particulier la courbe 3 représente le gain G (axe vertical, gauche) associé à la couche d'encapsulation en fonction de l'indice de réfraction N (axe horizontal inférieur), tandis que la courbe 4 représente le gain requis Gn (axe vertical droite) en fonction du rapport périmètre P sur surface S (axe horizontal supérieur) de la diode électroluminescente

La figure 8 est un abaque construit sur les mêmes principes que l'abaque de la figure 7, avec pour objectif de déterminer un indice de réfraction de la couche d'encapsulation pour lequel le rendement quantique externe de la diode est inférieur au rendement quantique externe maximum de ladite diode.

## EXPOSÉ DÉTAILLÉ DE MODES DE RÉALISATION PARTICULIERS

La présente invention concerne un procédé d'adaptation du rendement quantique externe d'une diode électroluminescente. En particulier, la présente invention concerne l'encapsulation d'une diode électroluminescente par une couche d'encapsulation dont l'indice de réfraction N est ajusté de sorte que ladite diode présente un rendement quantique externe prédéterminé, et notamment un rendement quantique externe maximum.

La détermination de l'indice de réfraction met en œuvre une modélisation des rendements quantiques interne et externe de la diode.

La figure 2 est une représentation schématique d'une diode électroluminescente 10 mise en œuvre dans le cadre de la présente invention.

Par « diode électroluminescente », on entend généralement une structure qui, dès lors qu'elle est traversée par un courant, émet un rayonnement lumineux par une face dite face électroluminescente 10a.

Par « rayonnement lumineux », on entend par exemple un rayonnement dans une gamme de longueurs d'ondes du domaine visible, par exemple dans une gamme de longueurs d'ondes comprise entre 400 nm et 700 nm.

La diode électroluminescente comprend une face opposée à la face électroluminescente 10a, et dite face arrière 10b.

La diode électroluminescente repose par sa face arrière 10b sur la face avant du substrat support 11.

La diode électroluminescente 10 est formée par un empilement de couches qui comprend une couche active intercalée entre une première couche de semi-conducteur et une seconde couche de semi-conducteur.

La première couche de semi-conducteur peut comprendre un matériau semi-conducteur III-V dopé n, et notamment du GaN de type n (par type n, on entend dopé avec des espèces donneuses d'électrons).

La seconde couche de semi-conducteur peut comprendre un matériau semi-conducteur III-V dopé p, notamment du GaN de type p (par type p, on entend dopé avec des espèces donneuses de trous).

La couche active peut comprendre au moins un des matériaux choisi parmi : GaN, GaAs, InGaN, InGaAIP. La couche active peut également comprendre un alliage ternaire ou quaternaire de semi-conducteurs III-V.

La couche active, la première couche de semi-conducteur et la seconde couche de semi-conducteur peuvent être formées par des techniques de dépôt de films par épitaxie sur la face avant 11a du substrat support 11.

La formation desdites couches fait appel à des techniques connues de l'homme du métier et n'est donc pas décrite en détails dans la présente invention.

La diode électroluminescente présente une surface S et un périmètre P.

Par « surface S » de la diode électroluminescente, on entend la surface de la face électroluminescente 10a.

Par « périmètre P » de la diode électroluminescente, on entend le périmètre de la face électroluminescente 10a.

Le procédé selon la présente invention comprend une étape d'encapsulation de la diode électroluminescente avec une couche d'encapsulation 12 d'indice N.

Il est entendu, sans qu'il soit nécessaire de le préciser, que l'indice N est considéré à la longueur d'onde λ du rayonnement lumineux émis par la diode électroluminescente.

Selon la présente invention, l'indice N de la couche d'encapsulation est ajusté de sorte que le rendement quantique externe de la diode électroluminescente soit égal à un rendement quantique externe prédéterminé $EQE_k$.

Une méthode de détermination de l'indice N répondant à cet objectif peut faire appel à une modélisation des rendements quantiques externe et interne d'une diode électroluminescente.

La suite de l'énoncé en présente un exemple, notamment pour l'atteinte d'un rendement quantique externe maximum noté $EQE_{max}$. Toutefois, il est important de noter que l'homme du métier, avec ses connaissances générales, et la description qui suit, pourra considérer un rendement quantique externe inférieur au rendement quantique externe maximum.

Le rendement quantique externe maximum atteignable par une diode électroluminescente est régi par l'empilement de couches formant cette dernière. Cependant, le rendement quantique externe maximum ne peut être atteint que dans des conditions d'extraction particulières du rayonnement lumineux émis par la diode électroluminescentes.

Ainsi, tel que précisé précédemment, l'invention se propose d'ajuster l'indice de réfraction N de la couche d'encapsulation de sorte que le rendement quantique externe de la diode, pour une taille donnée, soit égal au rendement quantique externe maximum $EQE_{max}$.

Le rendement quantique externe d'une diode électroluminescente vérifie la relation (1).

$$EQE = IQE \times LEE \qquad (1)$$

où

« IQE » représente le rendement quantique interne de la diode électroluminescente, et « LEE » l'efficacité de l'extraction lumineuse.

Le document [5] utilise au début un modèle de la littérature, dit modèle ABC, permettant de dériver le rendement quantique interne d'une diode électroluminescente.

Toutefois, le modèle ABC, tel que proposé dans la littérature [5] ne rend pas compte de l'effet de la taille de la diode électroluminescente sur le rendement quantique tel qu'illustré à la figure 1.

Les inventeurs proposent donc de pallier cette lacune en modifiant le modèle ABC comme suit (équation (2)):

$$IQE = \frac{B.n^2}{A'.\frac{P}{S}.n + B.n^2 + C.n^3} \qquad (2)$$

Où:

A'.P/S est un coefficient de recombinaison SRH non radiative, adapté à la géométrie de la diode,
B est un coefficient de recombinaison radiative,
C est un coefficient de recombinaison Auger non radiative,
n est une densité de porteurs injectés,
P est le périmètre de la diode électroluminescente,
S est la surface de la diode électroluminescente.

Une simulation du rendement quantique externe sur la base de ce modèle ABC modifié en fonction de la taille des diodes électroluminescentes, et rendant compte d'une extraction lumineuse de 0,14, est représentée à la figure 3. Cette simulation est conforme aux résultats expérimentaux de la figure 1, validant ainsi la relation (2).

Ainsi, compte tenu de la taille de la diode électroluminescente, et via la relation (2), la valeur maximale du rendement quantique interne $IQE_{max}$ de ladite diode vérifie la relation (3).

$$IQEmax = \frac{1}{1 + 2.\left(\frac{C}{B}\right).\left(\frac{A'}{C}\right)^{1/2}\sqrt{P/S}} \qquad (3)$$

L'extraction lumineuse LEE, permettant à la diode électroluminescente de présenter un rendement quantique externe maximum $EQE_{max} = K$, quelle que soit la taille de ladite diode, vérifie la relation (4).

$$LEE = K\left(1 + \alpha\sqrt{P/S}\right) \qquad \text{avec} \qquad \alpha = \frac{2}{B}\sqrt{A'.C} \qquad (4)$$

Tel qu'illustré à la figure 4, la modulation de l'extraction lumineuse en fonction de la taille de la diode électroluminescente permet à cette dernière de présenter un rendement quantique externe maximum quelle que soit sa taille. Néanmoins, le décalage vers les densités de courant croissantes lorsque la taille de la diode électroluminescente diminue est toujours observé.

La relation (4) représente donc un gain à appliquer au rendement quantique interne d'une diode électroluminescente de manière à ce que le rendement quantique externe de cette dernière soit maximum.

Les figures 5a et 5b sont des illustrations de l'évolution d'un tel gain. Notamment, la figure 5a représente le rendement quantique externe d'une diode électroluminescente avec (courbe 1) et sans (courbe 2) gain relatif à la modulation de l'extraction lumineuse en fonction de la taille de ladite diode.

La figure 5b représente le gain à appliquer pour chaque taille de diode permettant d'atteindre un rendement quantique externe maximum.

La connaissance du gain à appliquer, permet alors le dimensionnement de la couche d'encapsulation en termes d'indice de réfraction N de sorte que le rendement quantique externe de la diode électroluminescente soit égal au rendement quantique externe maximum $EQE_{max}$.

Ce dimensionnement peut notamment comprendre une simulation optique d'une extraction lumineuse par la couche d'encapsulation en fonction de l'indice de réfraction de cette dernière.

Cette simulation peut impliquer la détermination des différents rayons lumineux émis par une source lambertienne pour une gamme d'indices de réfraction donnée (par exemple variant entre 1 et 2,4). La figure 6 donne un exemple d'une telle simulation en considérant une couche d'encapsulation en forme de dôme et au centre de laquelle se trouve une source de rayonnement lumineux.

Un abaque (figure 7) mettant en correspondance la géométrie, et notamment le rapport périmètre P sur surface S, de la diode électroluminescente avec l'indice de réfraction N de la couche d'encapsulation peut alors être construit sur la base de cette simulation.

À cet égard, la figure 7 permet, en fonction de la géométrie de la diode, de déterminer l'indice de réfraction N de la couche d'encapsulation nécessaire à l'atteinte d'un rendement quantique externe maximum. En particulier, la courbe 3 représente le gain G (axe vertical, gauche) associé à la couche d'encapsulation en fonction de l'indice de réfraction N (axe horizontal inférieur), tandis que la courbe 4 représente le gain requis Gn (axe vertical, droite) en fonction du rapport périmètre P sur surface S de la diode électroluminescente (axe horizontal supérieur).

À titre d'exemple, pour un rapport P/S= $10^4$, le gain requis pour maximiser le rendement quantique externe de la diode est d'environ 1,8. Ce gain requis est obtenu pour une couche d'encapsulation présentant un indice de réfraction N égal à 1,7 (trajet « A »).

Toujours à titre d'exemple, pour un rapport P/S= $10^3$, le gain requis pour maximiser le rendement quantique externe de la diode est d'environ 1,2. Ce gain requis est obtenu pour une couche d'encapsulation présentant un indice de réfraction N égal à 1,48 (trajet « B »).

L'abaque présenté à la figure 7 est relatif à un rendement quantique externe maximum. Cependant, la méthode proposée dans le cadre de la présente invention est applicable à tout autre rendement inférieur au rendement quantique externe maximum. Notamment, la figure 8 est un abaque construit sur la base d'un rendement quantique à atteindre inférieur au rendement quantique maximum. Notamment, le rendement quantique extérieur considéré à la figure 8 est égal à 0,09 au lieu d'un $EQE_{max}$ de 0,14.

Le procédé selon la présente invention peut avantageusement être mis en œuvre pour ajuster l'extraction lumineuse d'une pluralité de diode, par exemple de manière à ce que le rendement quantique externe de ces dernières soit maximum. Ces diodes peuvent être identiques, ou présenter des tailles différentes.

De manière avantageuse, les diodes peuvent former un afficheur.

De manière complémentaire à la présente invention, la couche d'encapsulation peut être texturée sur sa surface exposée.

**Références 1 à 5:**

[1] US 2007/018183 A1 ;
[2] US 2016/111597 A1 ;
[3] JP 2003-282938 A ;
[4] WO 2013/179185 A1 ;
[5] F. Olivier et al., "Shockley-Read-Hall and Auger non-radiative recombination in GaN based LEDs: A size effect study" Appl. Phys. Lett. Vol. 111, no. 2, p. 022104, juillet 2017.

**Revendications**

1. Procédé d'adaptation de l'efficacité de l'extraction lumineuse LEE d'au moins une diode électroluminescente (10) de surface S et de périmètre P, le procédé comprenant une étape d'encapsulation de la diode électroluminescente par une couche d'encapsulation (12) présentant un indice de réfraction N, l'indice de réfraction N étant déterminé sur la base d'un modèle rendant compte d'un rendement quantique interne IQE de la diode électroluminescente, et de sorte que l'efficacité de l'extraction lumineuse résultant de la mise en œuvre de la couche d'encapsulation permette à la diode électroluminescente d'atteindre un rendement quantique externe prédéterminé EQE$_K$, et dans lequel le modèle est fonction du rapport du périmètre P sur la surface S de la diode électroluminescente.

2. Procédé selon la revendication 1, dans lequel le modèle rendant compte du rendement quantique interne IQE vérifie la relation suivante :

$$IQE = \frac{B.n^2}{A'.\frac{P}{S}.n + B.n^2 + C.n^3}$$

où :

A'.P/S est un coefficient de recombinaison Shockley-Read-Hall (SRH) non radiative,
B est un coefficient de recombinaison radiative,
C est un coefficient de recombinaison Auger non radiative,
n est une densité de porteurs injectés.

3. Procédé selon la revendication 1 ou 2, dans lequel la détermination de l'indice de réfraction N comprend une simulation de trajets de rayons lumineux émis par une source lambertienne encapsulée par la couche d'encapsulation.

4. Procédé selon la revendication 3, dans lequel la simulation est effectuée pour une gamme d'indices de réfraction de la couche d'encapsulation.

5. Procédé selon la revendication 4, dans lequel la détermination de l'indice de réfraction N comprend la construction d'un abaque mettant en relation l'extraction lumineuse permise par la couche d'encapsulation et l'extraction lumineuse requise pour que le rendement quantique externe de la diode soit égal au rendement quantique externe prédéterminé EQE$_K$.

6. Procédé selon l'une des revendications 1 à 5, dans lequel le rendement quantique externe prédéterminé EQE$_K$ correspond à une valeur maximale EQE$_{max}$ du rendement quantique atteignable par la diode électroluminescente.

7. Procédé selon l'une des revendications 1 à 6, dans lequel la couche d'encapsulation forme un dôme.

8. Procédé selon l'une des revendications 1 à 7, dans lequel le rapport du périmètre P sur la surface S est supérieur à un dixième.

9. Procédé selon l'une des revendications 1 à 8, dans lequel on adapte l'efficacité de l'extraction lumineuse LEE d'une pluralité de diodes électroluminescentes identiques.

10. Procédé selon l'une des revendications 1 à 8, dans lequel on adapte l'efficacité de l'extraction lumineuse LEE d'une pluralité de diodes électroluminescentes de tailles différentes.

11. Procédé selon l'une des revendications 1 à 10, dans lequel l'au moins une diode électroluminescente comprend un empilement de matériaux semi-conducteurs III-V.

**Patentansprüche**

1. Verfahren zum Anpassen der Lichtextraktionseffizienz LEE wenigstens einer Leuchtdiode (10) mit einer Fläche S und einem Umfang P, wobei das Verfahren einen Schritt des Einkapselns der Leuchtdiode durch eine Einkapselungsschicht (12) mit einem Brechungsindex N umfasst, wobei der Brechungsindex N auf der Grundlage eines Modells bestimmt wird, das eine interne Quantenausbeute IQE der Leuchtdiode wiedergibt, und so, dass die Effizienz der Lichtextraktion, die aus der Implementierung der Einkapselungsschicht resultiert, die Leuchtdiode in die Lage versetzt, eine vorbestimmte externe Quantenausbeute EQE$_K$ zu erreichen, und wobei das Modell eine Funktion des Verhältnisses des Perimeters P zur Oberfläche S der Leuchtdiode ist.

**2.** Verfahren nach Anspruch 1, wobei das Modell, das die interne Quantenausbeute IQE wiedergibt, die folgende Beziehung verifiziert:

$$IQE = \frac{B.n^2}{A'.\frac{P}{S}.n + B.n^2 + C.n^3}$$

wobei gilt:

A'.P/S ist ein nichtstrahlender Shockley-Read-Hall (SRH)-Rekombinationskoeffizient,
B ist ein strahlender Rekombinationskoeffizient,
C ist ein nichtstrahlender Auger-Rekombinationskoeffizient,
n ist eine Dichte injizierter Träger.

**3.** Verfahren nach Anspruch 1 oder 2, wobei die Bestimmung des Brechungsindex N eine Simulation von Lichtstrahlengängen umfasst, die von einer durch die Einkapselungsschicht eingekapselten Lambertschen Quelle emittiert werden.

**4.** Verfahren nach Anspruch 3, wobei die Simulation für einen Bereich von Brechungsindizes der Einkapselungsschicht durchgeführt wird.

**5.** Verfahren nach Anspruch 4, wobei die Bestimmung des Brechungsindex N die Erstellung eines Schaubilds umfasst, das die von der Einkapselungsschicht zugelassene Lichtausbeute mit der Lichtausbeute in Beziehung setzt, die erforderlich ist, damit die externe Quantenausbeute der Diode gleich der vorbestimmten externen Quantenausbeute $EQE_K$ ist.

**6.** Verfahren nach einem der Ansprüche 1 bis 5, wobei die vorbestimmte, externe Quantenausbeute $EQE_K$ einem Maximalwert $EQE_{max}$ der von der Leuchtdiode erreichbaren Quantenausbeute entspricht.

**7.** Verfahren nach einem der Ansprüche 1 bis 6, wobei die Einkapselungsschicht eine Kuppel bildet.

**8.** Verfahren nach einem der Ansprüche 1 bis 7, wobei das Verhältnis des Umfangs P zur Fläche S größer als ein Zehntel ist.

**9.** Verfahren nach einem der Ansprüche 1 bis 8, wobei die Effizienz der Lichtextraktion LEE einer Vielzahl von identischen Leuchtdioden angepasst wird.

**10.** Verfahren nach einem der Ansprüche 1 bis 8, wobei die Effizienz der LichtextraktionLEE einer Vielzahl von Leuchtdioden unterschiedlicher Größe angepasst wird.

**11.** Verfahren nach einem der Ansprüche 1 bis 10, wobei die wenigstens eine Leuchtdiode einen Stapel aus III-V-Halbleitermaterial umfasst.

**Claims**

**1.** Method of adapting light extraction efficiency LEE from at least one light emitting diode (10) with surface area S and perimeter P, the method comprising a step to encapsulate the light emitting diode with an encapsulation layer (12) with a refraction index N, the refraction index N being determined based on a model taking account of an internal quantum efficiency IQE of the light emitting diode, and such that extraction of light resulting from use of the encapsulation layer is such that the light emitting diode can achieve a predetermined external quantum efficiency $EQE_K$, and wherein the model is a function of the ratio of the perimeter P to the surface area S of the light emitting diode.

**2.** Method according to claim 1, wherein the model taking account of the internal quantum efficiency IQE satisfies the following relation:

$$IQE = \frac{B.n^2}{A'.\frac{P}{S}.n + B.n^2 + C.n^3}$$

in which:

A'.P/S is an Shockley-Hall-Read (SRH) non-radiative recombination coefficient,
B is a radiative recombination coefficient,
C is an Auger non-radiative recombination coefficient,
n is an injected carriers density.

3. Method according to claim 1 or 2, wherein determination of the refraction index N comprises a simulation of the path of light rays emitted by a lambertian source encapsulated by the encapsulation layer.

4. Method according to claim 3, wherein the simulation is made for a range of refraction indices of the encapsulation layer.

5. Method according to claim 4, wherein determination of the refraction index N comprises the construction of an abacus illustrating the relation between light extraction allowed by the encapsulation layer and required light extraction so that the external quantum efficiency of the diode is equal to the predetermined external quantum efficiency $EQE_K$.

6. Method according to one of claims 1 to 5, wherein the predetermined external quantum efficiency $EQE_K$ corresponds to a maximum value $EQE_{max}$ of the quantum efficiency that can be achieved by the light emitting diode.

7. Method according to one of claims 1 to 6, wherein the encapsulation layer forms a dome.

8. Method according to one of claims 1 to 7, wherein the ratio of the perimeter P to the surface area S is more than one tenth.

9. Method according to one of claims 1 to 8, wherein the light extraction efficiency LEE of a plurality of identical light emitting diodes is adapted.

10. Method according to one of claims 1 to 8, wherein the light extraction efficiency LEE of a plurality of different sizes of light emitting diodes is adapted.

11. Method according to one of claims 1 to 10, wherein the at least one light emitting diode comprises a stack of III-V semiconducting materials.

FIG.1

FIG.2

FIG.3

FIG.4

FIG.5a

FIG.5b

FIG.6

FIG.7

FIG.8

**EP 3 664 170 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2007018183 A1
- US 2016111597 A1
- JP 2003282938 A
- WO 2013179185 A1

**Littérature non-brevet citée dans la description**

- **MING MA et al.** Effects of the refractive index of the encapsulant on the light-extraction efficiency of light-emitting diodes. *Optics Express,* 12 Septembre 2011, vol. 19 (S5), A1135-A1140
- **F. OLIVIER et al.** Shockley-Read-Hall and Auger non-radiative recombination in GaN based LEDs: A size effect study. *Appl. Phys. Lett.,* Juillet 2017, vol. 111 (2), 022104